# EUROPEAN PATENT APPLICATION

(11) **EP 4 611 495 A1**
(43) Date of publication of application: **03.09.2025**
(21) Application number: 24771057.7
(22) Date of filing: 26.01.2024
(51) Int. Cl.: H05K 7/20, C09K 5/02, H05K 9/00, H04M 1/02

(54) **ELECTRONIC DEVICE COMPRISING THERMAL INTERFACE MATERIAL HAVING PHASE CHANGE MATERIAL**

(30) Priority: 10.03.2023 KR 20230032091; 04.04.2023 KR 20230044418
(71) Applicant: Samsung Electronics Co., Ltd., Suwon-si, Gyeonggi-do 16677 (KR)
(72) Inventor: LEE, Sungbok, Suwon-si Gyeonggi-do 16677 (KR); JUNG, Dongkee, Suwon-si Gyeonggi-do 16677 (KR); LEE, Kyuhwan, Suwon-si Gyeonggi-do 16677 (KR); LEE, Haejin, Suwon-si Gyeonggi-do 16677 (KR); HWANG, Jieun, Suwon-si Gyeonggi-do 16677 (KR); KIM, Myungjun, Suwon-si Gyeonggi-do 16677 (KR); PARK, Min, Suwon-si Gyeonggi-do 16677 (KR); YANG, Sunga, Suwon-si Gyeonggi-do 16677 (KR)
(74) Representative: HGF
(86) International application number: PCT/KR2024/001284
(87) International publication number: WO 2024/191056

(57) **Abstract**

An electronic device, according to one embodiment, comprises: an electronic component; a shield can having an opening aligned with the electronic component; a shielding sheet disposed on the shield can; and a thermal interface material (TIM) configured to transfer heat generated from the electronic component to the shielding sheet, and extending from the electronic component to the shielding sheet through at least a portion of the opening. The thermal interface material includes a phase change material (PCM) and is at least partially included within the shielding sheet.

## Description

### [Technical Field]

The disclosure relates to an electronic device including a thermal interface material having a phase change material.

### [Background Art]

An electronic device may include a plurality of electronic components to implement various functions. When operating by consuming power, an electronic component may generate heat. Heat generated from the electronic component may cause a deterioration in a function of the electronic device by increasing a temperature of the electronic component. The electronic device may include a heat dissipation member for radiating heat generated from the electronic component. The heat dissipation member may include a thermal interface material (TIM) configured to transfer heat.

The above-described information may be provided as a related art for the purpose of helping to understand the present disclosure. No claim or determination is raised as to whether any of the above-described information may be applied as a prior art related to the present disclosure.

### [Disclosure]

### [Technical Solution]

According to an example embodiment, an electronic device may include: an electronic component, a shield can, a shielding sheet, and a thermal interface material. The electronic component may be disposed on a printed circuit board. The shield can may at least partially surround the electronic component. The shield can may be disposed on the printed circuit board. The shield can may include a first surface, a second surface, and an opening. The first surface may face the electronic component. The second surface may face the first surface. The opening may pass through the first surface and the second surface. The opening may be aligned with the electronic component. The shielding sheet may be disposed on the second surface of the shield can to cover the opening of the shield can. The thermal interface material may be configured to transfer heat generated from the electronic component to the shielding sheet. The thermal interface material may extend from a third surface facing the first surface of the electronic component to the shielding sheet through at least a portion of the opening. The thermal interface material may include a phase change material (PCM). The thermal interface material may be at least partially included in the shielding sheet.

According to an embodiment, an electronic device may include: a housing, a display, an electronic component, a shield can, a shielding sheet, and a thermal interface material. The housing may include a first plate, a second plate, and a supporting member comprising a support. The second plate may be opposite to the first plate. The supporting member may be disposed between the first plate and the second plate. The display may be disposed between the supporting member and the first plate. The electronic component may be disposed on a surface of the supporting member facing the first plate. The shield can may at least partially surround the electronic component. The shield can may be disposed on the surface of the printed circuit board. The shield can may include a first surface, a second surface, and an opening. The first surface may face the electronic component. The second surface may face the first surface. The opening may pass through the first surface and the second surface. The opening may be aligned with the electronic component. The shielding sheet may be disposed on the second surface of the shield can to cover the opening of the shield can. The thermal interface material may be configured to transfer heat generated from the electronic component to the shielding sheet. The thermal interface material may extend from a third surface of the electronic component facing the first surface to the shielding sheet through at least a portion of the opening. The thermal interface material may include a phase change material (PCM). The thermal interface material may be at least partially included in the shielding sheet.

### [Description of the Drawings]

The above and other aspects, features and advantages of certain embodiments of the present disclosure will be more apparent from the following detailed description, taken in conjunction with the accompanying drawings, in which:
FIG. 1 is a block diagram of an electronic device in a network environment according to an embodiment.
FIG. 2 illustrates an exemplary electronic device.
FIG. 3 is an exploded perspective view of an exemplary electronic device.
FIG. 4 is a view in which an exemplary shield can is viewed from above.
FIG. 5A is a cross-sectional view of an exemplary electronic device cut along a line A-A' of FIG. 4.
FIG. 5B is an SEM photograph indicating an interface between a shielding sheet and a thermal interface material of FIG. 5A.
FIG. 5C is a graph indicating a junction temperature of an electronic component in accordance with a contact area between a thermal interface material and the electronic component.
FIG. 6 is a cross-sectional view of an exemplary electronic device cut along line B-B' of FIG. 4.
FIG. 7 is a cross-sectional view of an exemplary electronic device cut along line C-C' of FIG. 4.
FIG. 8A schematically illustrates a process of manufacturing a thermal interface material and a shielding sheet according to a comparative example.
FIG. 8B schematically illustrates an exemplary process of manufacturing a thermal interface material and a shielding sheet.
FIG. 9 is an SEM photograph indicating an interface between a shielding sheet and a thermal interface material manufactured through a manufacturing process of FIG. 8A.
FIG. 10 schematically illustrates an exemplary shielding sheet.
FIG. 11A illustrates an example of an unfolding state of an electronic device, according to an embodiment.
FIG. 11B illustrates an example of a folding state of an electronic device, according to an embodiment.
FIG. 11C is an exploded view of an electronic device according to an embodiment.

### [Mode for Invention]

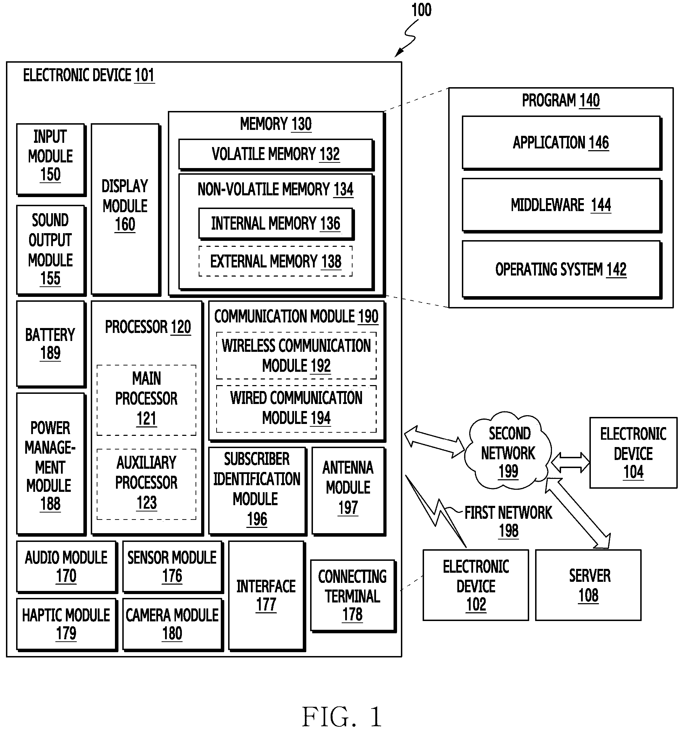

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

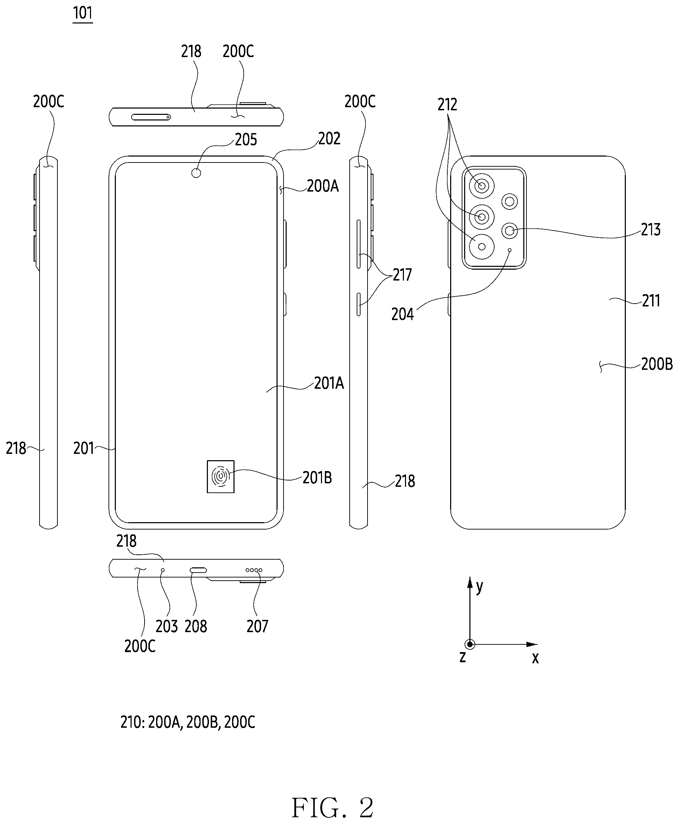

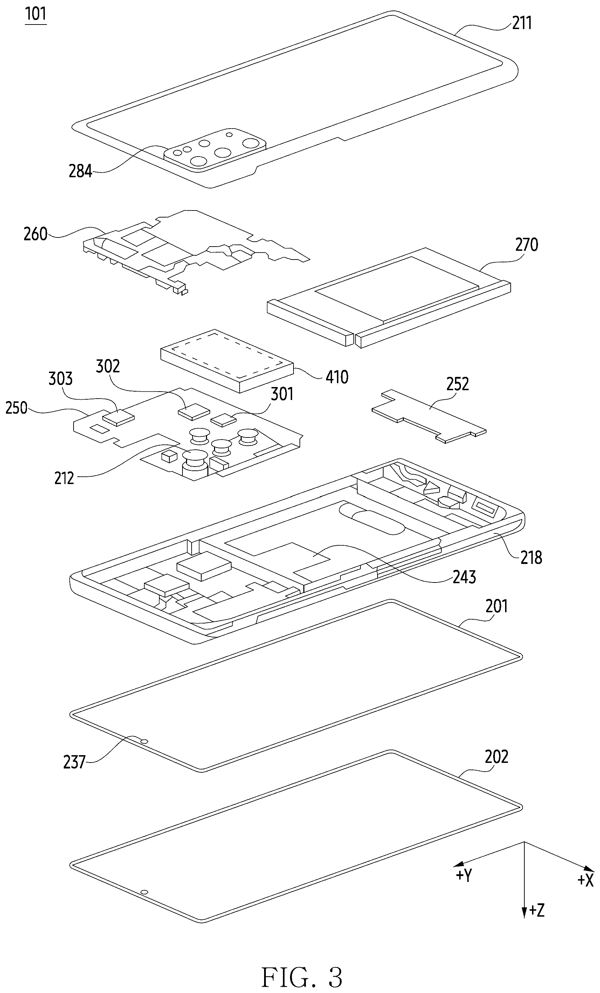

FIG. 2 illustrates an exemplary electronic device. FIG. 3 is an exploded perspective view of an exemplary electronic device.

Referring to FIGS. 2 and 3, according to an embodiment, an electronic device 101 may include a housing 210 forming the exterior of the electronic device 101. For example, the housing 210 may include a first surface (or front surface) 200A, a second surface (or rear surface) 200B, and a third surface (or side surface) 200C surrounding a space between the first surface 200A and the second surface 200B. According to an embodiment, the housing 210 may refer to a structure forming at least a portion of the first surface 200A, the second surface 200B, and/or the third surface 200C.

According to an embodiment, the electronic device 101 may include a substantially transparent first plate 202. According to an embodiment, the first plate 202 may form at least a portion of the first surface 200A. According to an embodiment, the first plate 202 may include, for example, a glass plate or a polymer plate including various coating layers, but is not limited thereto. The first plate 202 may be referred to as a front plate.

According to an embodiment, the electronic device 101 may include a substantially opaque second plate 211. According to an embodiment, the second plate 211 may form at least a portion of the second surface 200B. According to an embodiment, the second plate 211 may be formed by coating or coloring glass, ceramic, polymer, metal (e.g., aluminum, stainless steel (STS), or magnesium), or a combination of at least two of the above materials. The second plate 211 may be referred to as a rear plate.

According to an embodiment, the electronic device 101 may include a side member (e.g., a side member 218 of FIG. 3). According to an embodiment, the side member 218 may be coupled to the first plate 202 and/or the second plate 211 to form at least a portion of the third surface 200C of the electronic device 101. For example, the side member 218 may fully form the third surface 200C of the electronic device 101. For example, the side member 218 may form the third surface 200C of the electronic device 101 together with the first plate 202 and/or the second plate 211.

Unlike the illustrated embodiment, when the third surface 200C of the electronic device 101 is partially formed by the first plate 202 and/or the second plate 211, the first plate 202 and/or the second plate 211 may include an area bent toward the second plate 211 and/or the first plate 202 at an edge thereof and extending seamlessly. For example, the extended area of the first plate 202 and/or the second plate 211 may be located at both ends of a long edge of the electronic device 101, but it is not limited by the above-described example.

According to an embodiment, the side member 218 may include a metal and/or a polymer. According to an embodiment, the second plate 211 and the side member 218 may be integrally formed, and may include the same material (e.g., a metal material such as aluminum), but are not limited thereto. For example, the second plate 211 and the side member 218 may be formed in separate configurations and/or may include different materials.

According to an embodiment, the electronic device 101 may include at least one of a display 201, an audio module 203, 204, and 207, a sensor module (not shown), a camera module 205, 212, and 213, a key input device 217, a light emitting device (not shown), and/or a connector hole 208. According to an embodiment, the electronic device 101 may omit at least one of the above components (e.g., the key input device 217 or the light emitting device (not shown), or may additionally include another component.

According to an embodiment, the display 201 (e.g., the display module 160 of FIG. 1) may be visible through a large portion of the first plate 202. For example, at least a portion of the display 201 may be seen through the first plate 202 forming the first surface 200A. According to an embodiment, the display 201 may be disposed on a rear surface of the first plate 202.

According to an embodiment, an outside shape of the display 201 may be formed substantially the same as an outside shape of the first plate 202 adjacent to the display 201. According to an embodiment, an interval between the outside of the display 201 and the outside of the first plate 202 may be formed substantially the same, in order to expand an area in which the display 201 is visible.

According to an embodiment, the display 201 (or the first surface 200A of the electronic device 101) may include a screen display area 201A. According to an embodiment, the display 201 may provide visual information to a user through the screen display area 201A. In the illustrated embodiment, when the first surface 200A is viewed from front, the screen display area 201A is illustrated to be spaced apart from the outside of the first surface 200A and be located inside the first surface 200A, but it is not limited thereto. According to an embodiment, when the first surface 200A is viewed from the front, at least a portion of an edge of the screen display area 201A may substantially match an edge of the first surface 200A (or the first plate 202).

According to an embodiment, the screen display area 201A may include a sensing area 201B configured to obtain biometric information of a user. Herein, the meaning of "the screen display area 201A includes the sensing area 201B" may be understood that at least a portion of the sensing area 201B is overlapped on the screen display area 201A. For example, the sensing area 201B may refer to an area capable of displaying visual information by the display 201 and additionally obtaining the user's biometric information (e.g., fingerprint), similar to another area of the screen display area 201A. According to an embodiment, the sensing area 201B may be formed in the key input device 217.

According to an embodiment, the display 201 may include an area in which the first camera module 205 (e.g., the camera module 180 of FIG. 1) is located. According to an embodiment, an opening is formed in the area of the display 201, and the first camera module 205 (e.g., a punch hole camera) may be disposed at least partially within the opening to face the first surface 200A. In this case, the screen display area 201A may surround at least a portion of edge of the opening. According to an embodiment, the first camera module 205 (e.g., an under display camera (UDC)) may be disposed under the display 201 in order to overlap the area of the display 201. In this case, the display 201 may provide visual information to the user through the area, and additionally, the first camera module 205 may obtain an image corresponding to a direction toward the first surface 200A through the area of the display 201.

According to an embodiment, the display 201 may be coupled to or disposed adjacent to a touch sensing circuit, a pressure sensor capable of measuring intensity (pressure) of a touch, and/or a digitizer detecting a magnetic field-type stylus pen.

According to an embodiment, the audio modules 203, 204, and 207 (e.g., the audio module 170 of FIG. 1) may include a microphone hole 203 and 204 and a speaker hole 207.

According to an embodiment, the microphone hole 203 and 204 may include a first microphone hole 203 formed in a partial area of the third surface 200C and a second microphone hole 204 formed in a partial area of the second surface 200B. A microphone (not shown) for obtaining an external sound may be disposed inside the microphone holes 203 and 204. The microphone may include a plurality of microphones to detect a direction of sound.

According to an embodiment, the second microphone hole 204 formed in a partial area of the second surface 200B may be disposed adjacent to the camera modules 205, 212, and 213. For example, the second microphone hole 204 may acquire sound according to an operation of the camera module 205, 212, and 213. However, it is not limited thereto.

According to an embodiment, the speaker hole 207 may include an external speaker hole 207 and a receiver hole for calling (not shown). The external speaker hole 207 may be formed on a portion of the third surface 200C of the electronic device 101. According to an embodiment, the external speaker hole 207 and the microphone hole 203 may be implemented as one hole. Although not shown, the receiver hole for calling (not shown) may be formed on another portion of the third surface 200C. For example, the receiver hole for calling may be formed on the third surface 200C opposite the external speaker hole 207. For example, based on the illustration of FIG. 2, the external speaker hole 207 may be formed on the third surface 200C corresponding to a lower end of the electronic device 101, and the receiver hole for calling may be formed on the third surface 200C corresponding to an upper end of the electronic device 101. However, it is not limited thereto, and according to an embodiment, the receiver hole for calling may be formed at a position other than the third surface 200C. For example, the receiver hole for calling may be formed by a space spaced between the first plate 202 (or the display 201) and the side member 218.

According to an embodiment, the electronic device 101 may include a speaker module configured to output an audio signal to the outside of the housing 210 through the external speaker hole 207 and/or the receiver hole for calling (not shown).

According to an embodiment, a sensor module (not shown) (e.g., the sensor module 176 of FIG. 1) may generate an electrical signal or data value corresponding to an internal operating state of the electronic device 101 or an external environmental state. For example, the sensor module may include at least one of a proximity sensor, an HRM sensor, a fingerprint sensor, a gesture sensor, a gyro sensor, an air pressure sensor, a magnetic sensor, an acceleration sensor, a grip sensor, a color sensor, an infrared (IR) sensor, a biometric sensor, a temperature sensor, a humidity sensor, or an illuminance sensor.

According to an embodiment, the camera modules 205, 212, and 213 (e.g., the camera module 180 of FIG. 1) may include a first camera module 205 disposed to face the first surface 200A of the electronic device 101, a second camera module 212 disposed to face the second surface 200B, and a flash 213.

According to an embodiment, the second camera module 212 may include a plurality of cameras (e.g., dual camera, triple camera, or quad camera). However, the second camera module 212 is not limited to including a plurality of cameras, and may include one camera.

According to an embodiment, the first camera module 205 and the second camera module 212 may include one or more lenses, an image sensor, and/or an image signal processor.

According to an embodiment, the flash 213 may include, for example, a light emitting diode or a xenon lamp. According to an embodiment, two or more lenses (infrared camera, wide-angle and telephoto lens) and image sensors may be disposed on one surface of the electronic device 101.

According to an embodiment, the key input device 217 (e.g., the input module 150 of FIG. 1) may be disposed on the third surface 200C of the electronic device 101. According to an embodiment, the electronic device 101 may not include some or all of the key input devices 217, and the key input device 217 that is not included may be implemented on the display 201 in another form such as a soft key.

According to an embodiment, the connector hole 208 may be formed on the third surface 200C of the electronic device 101 so that a connector of the external device may be accommodated. A connection terminal (e.g., the connecting terminal 178 of FIG. 1) electrically connected to the connector of the external device may be disposed in the connector hole 208. According to an embodiment, the electronic device 101 may include an interface module (e.g., the interface 177 of FIG. 1) for processing an electrical signal transmitted and received through the connection terminal.

According to an embodiment, the electronic device 101 may include a light emitting device (not shown). For example, the light emitting device (not shown) may be disposed on the first surface 200A of the housing 210. The light emitting device (not shown) may provide state information of the electronic device 101 in an optical form. According to an embodiment, the light emitting device (not shown) may provide a light source linked with an operation of the first camera module 205. For example, the light emitting device (not shown) may include an LED, an IR LED, and/or a xenon lamp.

Referring to FIG. 3, according to an embodiment, the electronic device 101 may include a side member 218, a supporting member 243, a printed circuit board 250, a sub-printed circuit board 252, a cover plate 260, and a battery 270.

According to an embodiment, the electronic device 101 may include the side member 218 forming the exterior (e.g., the third surface 200C of FIG. 2) of the electronic device 101 and the supporting member 243 extending inward from the side member 218. According to an embodiment, the side member 218 and the supporting member 243 may be disposed between the display 201 and the second plate 211. For example, the side member 218 may surround a space between the second plate 211 and the first plate 202 (and/or the display 201). For example, the supporting member 243 may extend from the side member 218 within the space.

According to an embodiment, the supporting member 243 may support or accommodate other components included in the electronic device 101. For example, the display 201 may be disposed on a surface of the supporting member 243 facing a direction (e.g., +z direction), and the display 201 may be supported by the supporting member 243. For example, the printed circuit board 250, the sub-printed circuit board 252, the battery 270, and the second camera module 212 may be disposed on another surface of the supporting member 243 facing another direction (e.g., -z direction) opposite the direction. The printed circuit board 250, the sub-printed circuit board 252, the battery 270, and the second camera module 212 may be respectively seated in recesses defined by the side member 218 and/or the supporting member 243 of a frame structure 240.

According to an embodiment, the printed circuit board 250, the sub-printed circuit board 252, and the battery 270 may be coupled with the supporting member 243, respectively. For example, the printed circuit board 250 and the sub-printed circuit board 252 may be fixedly disposed on the supporting member 243 through a coupling member such as a screw. For example, the battery 270 may be fixedly disposed on the supporting member 243 through an adhesive member (e.g., double-sided tape). However, it is not limited by the above-described example.

According to an embodiment, the cover plate 260 may be disposed between the printed circuit board 250 and the second plate 211. According to an embodiment, the cover plate 260 may be disposed on the printed circuit board 250. For example, the cover plate 260 may be disposed on a surface of the printed circuit board 250 facing the -z direction.

According to an embodiment, the cover plate 260 may at least partially overlap the printed circuit board 250 with respect to the z-axis. According to an embodiment, the cover plate 260 may cover at least a partial area of the printed circuit board 250. Accordingly, the cover plate 260 may protect the printed circuit board 250 from physical impact or prevent/reduce the connector coupled to the printed circuit board 250 from being separated.

According to an embodiment, the cover plate 260 may be fixedly disposed on the printed circuit board 250 through a coupling member (e.g., a screw), or may be coupled to the supporting member 243 together with the printed circuit board 250 through the coupling member.

According to an embodiment, the display 201 may be disposed between the supporting member 243 and the first plate 202. For example, the first plate 202 may be disposed on a side (e.g., +z direction) of the display 201, and the supporting member 243 may be disposed on another side (e.g., -z direction).

According to an embodiment, the first plate 202 may be coupled with the display 201. For example, the first plate 202 and the display 201 may be adhered to each other, through an optical adhesive member (e.g., optically clear adhesive (OCA) or optically clear resin (OCR)) interposed therebetween.

According to an embodiment, the first plate 202 may be coupled with the side member 218. For example, the first plate 202 may include an outer portion extending outside the display 201 when viewed in the z-axis direction, and may be adhered to the side member 218, through an adhesive member (e.g., double-sided tape) disposed between the outer portion of the first plate 202 and the side member 218. However, it is not limited by the above-described example.

According to an embodiment, the printed circuit board 250 and/or the sub-printed circuit board 252 may be equipped with a processor (e.g., the processor 120 of FIG. 1), a memory (e.g., the memory 130 of FIG. 1), and/or an interface (e.g., the interface 177 of FIG. 1). For example, the processor may include one or more of a central processing unit, an application processor, a graphic processing device, an image signal processor, a sensor hub processor, or a communication processor. For example, the memory may include a volatile memory or a non-volatile memory. For example, the interface may include a high definition multimedia interface (HDMI), a universal serial bus (USB) interface, an SD card interface, and/or an audio interface. The interface may electrically or physically connect the electronic device 101 to an external electronic device, and may include an USB connector, an SD card/MMC connector, or an audio connector. According to an embodiment, the printed circuit board 250 and the sub-printed circuit board 252 may be operatively or electrically connected to each other through a connection member (e.g., a flexible printed circuit board).

According to an embodiment, the battery 270 (e.g., the battery 189 of FIG. 1) may supply power to at least one component of the electronic device 101. For example, the battery 270 may include a rechargeable secondary battery or a fuel cell. At least a portion of the battery 270 may be disposed on substantially the same plane as the printed circuit board 250 and/or the sub-printed circuit board 252.

According to an embodiment, the electronic device 101 may include an antenna module (not shown) (e.g., the antenna module 197 of FIG. 1). According to an embodiment, the antenna module may be disposed between the second plate 211 and the battery 270. For example, the antenna module may include a near field communication (NFC) antenna, a wireless charging antenna, and/or a magnetic secure transmission (MST) antenna. For example, the antenna module may perform short-range communication with an external device or wirelessly transmit and receive power with the external device.

According to an embodiment, the first camera module 205 (e.g., the front camera) may be disposed on at least a portion of the supporting member 243 so that a lens may receive external light through a partial area (e.g., the camera area 237) of the first plate 202 (e.g., the front surface 200A of FIG. 2).

According to an embodiment, the second camera module 212 (e.g., rear camera) may be disposed between the supporting member 243 and the second plate 211. According to an embodiment, the second camera module 212 may be electrically connected to the printed circuit board 250 through a connection member (e.g., a connector). According to an embodiment, the second camera module 212 may be disposed so that a lens may receive external light through a camera area 284 of the second plate 211 of the electronic device 101.

According to an embodiment, the camera area 284 may be formed on a surface (e.g., the rear surface 200B of FIG. 2) of the second plate 211. According to an embodiment, the camera area 284 may be formed at least partially transparent so that external light may be incident on a lens of the second camera module 212. According to an embodiment, at least a portion of the camera area 284 may protrude from the surface of the second plate 211 to a specific height. However, it is not limited thereto, and according to an embodiment, the camera area 284 may form substantially the same plane as a surface of the second plate 211.

According to an embodiment, the housing 210 of the electronic device 101 may refer to a configuration or structure that forms at least a portion of the exterior of the electronic device 101. In this regard, at least a portion of the first plate 202, the side member 218, and/or the second plate 211 forming the exterior of the electronic device 101 may be referred to as the housing 210 of the electronic device 101.

According to an embodiment, the electronic device 101 may include a shield can 410 covering at least a portion of the printed circuit board 250. The printed circuit board 250 may include a plurality of conductive layers and a plurality of non-conductive layers alternately laminated with the plurality of conductive layers. The printed circuit board 250 may provide electrical connection between electronic components 301, 302, and 303 disposed on the printed circuit board 250, using wiring and conductive via formed by the conductive layers.

For example, the shield can 410 may at least partially surround the electronic components 301 and 302 disposed on the printed circuit board 250. For example, the shield can 410 may be disposed on at least a partial area of the printed circuit board 250. The electronic components 301 and 302 disposed between the printed circuit board 250 and the shield can 410 may be accommodated in a space surrounded by the shield can 410. The shield can 410 may be configured to block electromagnetic interference between the electronic components 301 and 302 accommodated in the shield can 410 and an electronic component 303 outside the shield can 410. The shield can 410 may be configured to shield an electromagnetic wave emitted from the electronic components 301 and 302 accommodated in the shield can 410 from reaching another electronic component 303 outside the shield can 410 and shield an electromagnetic wave emitted from the other electronic component 303 from flowing into the shield can 410.

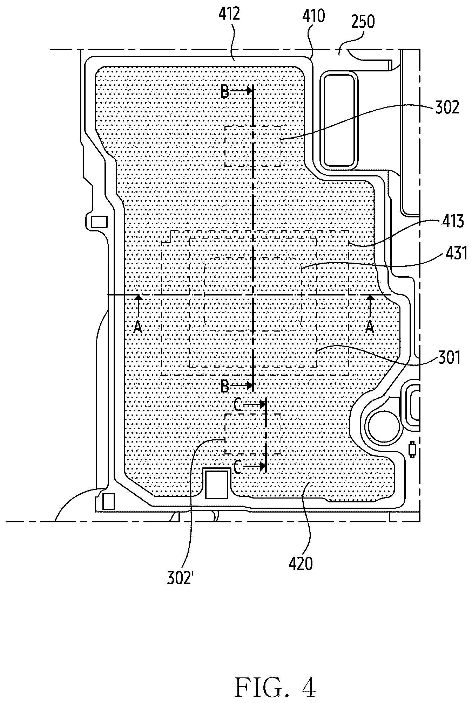

FIG. 4 is a view in which an exemplary shield can is viewed from above.

Referring to FIG. 4, according to an embodiment, an electronic device (e.g., the electronic device 101 of FIG. 2) may include an electronic component 301, a shield can 410, a shielding sheet 420, and a thermal interface material (TIM) 431.

According to an embodiment, the electronic component 301 may be disposed on a printed circuit board 250. For example, the electronic component 301 may be connected with a conductive layer of the printed circuit board 250 to be electrically connected to another component of the electronic device 101. The electronic component 301 may be a component for implementing various functions of the electronic device 101.

According to an embodiment, the shield can 410 may be disposed on the printed circuit board 250 to surround at least partially the electronic component 301. The shield can 410 may be configured to shield noise related to the electronic component 301 that is at least partially surrounded by the shield can 410. For example, when the electronic component 301 operates, an electromagnetic wave may be generated from the electronic component 301. When the electromagnetic wave is transferred to another electronic component (e.g., another electronic component 303 of FIG. 3), a malfunction of the other electronic component 303 may be caused, thereby interfering with normal operation of the other electronic component 303. For example, in case that an electromagnetic wave generated when another electronic component 303 operates is transferred to the electronic component 301, the normal operation of the electronic component 301 may be interrupted. The shield can 410 may be configured to shield an electromagnetic wave emitted by operation of the electronic component 301 from being transferred to the other electronic component 303 by at least partially surrounding the electronic component 301. The shield can 410 may be configured to shield an electromagnetic wave emitted from the other electronic component 303 from being transferred to the electronic component 301. For example, the shield can 410 may include a conductive material (e.g., metal) and may be electrically connected to a ground layer of the printed circuit board 250, in order to shield electromagnetic waves acting as noise.

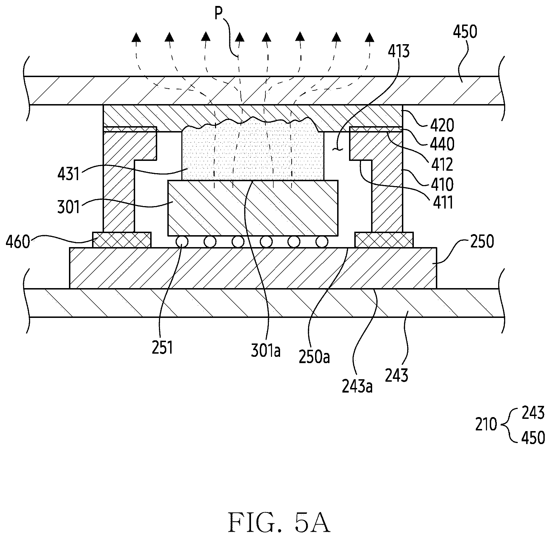

According to an embodiment, when the electronic component 301 operates, the electronic component 301 may generate heat. Heat generated from the electronic component 301 may increase a temperature of the electronic device 101, thereby causing a decrease in a function of a component of the electronic device 101 and a decrease in lifespan. The shield can 410 may include an opening 413 to provide a path for transferring heat emitted from the electronic component 301 to the outside of the shield can 410. The shield can 410 may include a first surface 411 facing the electronic component 301 and a second surface 412 facing the first surface (e.g., a first surface 411 of FIG. 5A). The opening 413 may pass through the first surface 411 and the second surface 412.

For example, the opening 413 may be aligned with the electronic component 301. "The opening 413 is aligned with the electronic component 301" may refer, for example, to the opening 413 and the electronic component 301 at least partially overlapping when the shield can 410 is viewed from above. When the opening 413 is not overlapping the electronic component 301, heat generated from the electronic component 301 may not escape to the outside of the shield can 410 and remain inside the shield can 410, thereby causing an increase in temperature of the electronic components 301 and 302 between the shield can 410 and the printed circuit board 250. As the opening 413 is aligned with the electronic component 301, heat generated from the electronic component 301 may be transferred to the outside of the shield can 410 through the opening 413.

According to an embodiment, the shielding sheet 420 may be configured to shield inflow and/or outflow of an electromagnetic wave through the opening 413. For example, the shielding sheet 420 may be disposed on the second surface 412 of the shielding-can 410 to cover the opening 413. The shielding sheet 420 may improve electromagnetic interference (EMI) shielding performance by covering the opening 413, which is an open area of the shield can 410. For example, the shielding sheet 420 may be attached to the second surface 412, through an adhesive member (e.g., an adhesive member 440 of FIG. 5A) between the second surface 412 and the shielding sheet 420. When the opening 413 aligned with the electronic component 301 is not covered, an electromagnetic wave emitted from the electronic component 301 may be transferred to another electronic component 303 through the opening 413, or an electromagnetic wave emitted from the other electronic component 303 may be transferred to the electronic component 301 through the opening 413. The shielding sheet 420 may shield the inflow and/or outflow of an electromagnetic wave into the shield can 410 through the opening 413, by covering the opening 413. For example, the shielding sheet 420 may include a material capable of shielding the electromagnetic wave. For example, the shielding sheet 420 may include a composite material to which a filler such as carbon fiber, carbon black, carbon nanotube (CNT), and nickel coated graphite is added, but is not limited thereto.

According to an embodiment, the thermal interface material 431 may be configured to transfer heat generated from the electronic component 301 to the shielding sheet 420. For example, the thermal interface material 431 may contact each of the electronic components 301 and the shielding sheet 420. For example, the thermal interface material 431 may extend from the electronic component 301 to the shielding sheet 420 through at least a portion of the opening 413.

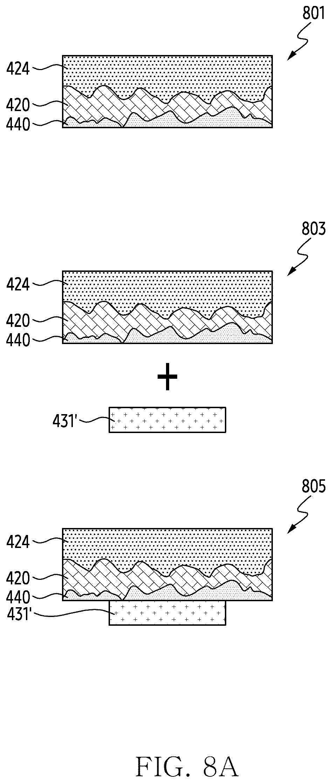

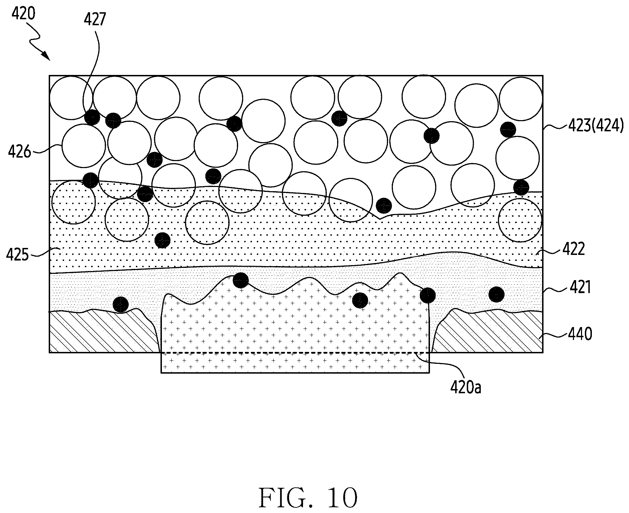

The thermal interface material 431 may enhance thermal coupling between the thermal interface material 431 and the shielding sheet 420. For example, the heat generated from the electronic component 301 may be effectively diffused to the shielding sheet 420 through the thermal interface material 431. For example, the heat generated during an operation of the electronic component 301 may be transferred to the thermal interface material 431 and may be transferred to the shielding sheet 420 through the thermal interface material 431. At least a portion of the shielding sheet 420 may include a heat dissipation layer (e.g., a third layer 423 of FIG. 10) for radiating the heat transferred from the thermal interface material 431 to the outside of the shielding sheet 420. For example, the shielding sheet 420 may include another thermal interface material (e.g., another thermal interface material 424 of FIG. 8A). The other thermal interface material 424 may transfer the heat transferred to the shielding sheet 420 to the outside of the shielding sheet 420.

The other thermal interface material 424 included in the shielding sheet 420 may be distinguished from the thermal interface material 431 disposed between the electronic component 301 and the shielding sheet 420. For example, the thermal interface material 431 may include a phase change material, a matrix including rubber, and a heat dissipation particle to be described in greater detail below, but the other thermal interface material 424 may not include the phase change material. As described in greater detail below, the thermal interface material 431 may include the phase change material to be at least partially included in the shielding sheet 420 through a phase change process, but the other thermal interface material 424 may not require a phase change.

For example, the heat generated from the electronic component 301 may be radiated through the electronic component 301, the thermal interface material 431, and the shielding sheet 420. For example, a conduction path (e.g., a conduction path P in FIG. 5A) for dissipating heat generated from the electronic component 301 may be formed along the electronic component 301, the thermal interface material 431, and the shielding sheet 420. In order to effectively radiate heat along the conduction path P, securing a contact area between the electronic component 301 and the thermal interface material 431 and/or smooth heat transfer between the thermal interface material 431 and the shielding sheet 420 may be required.

For example, the heat generated from the electronic component 301 may be transferred to the thermal interface material 431 through the contact area between the electronic component 301 and the thermal interface material 431. When the contact area between the electronic component 301 and the thermal interface material 431 is not secured, it may be difficult for the heat generated from the electronic component 301 to be transferred to the thermal interface material 431.

For example, since the thermal interface material 431 and the shielding sheet 420 include different materials, interfacial thermal resistance that interrupts heat dissipation between the thermal interface material 431 and the shielding sheet 420 may be high. When the heat generated from the electronic component 301 is not radiated due to high interfacial thermal resistance, the electronic component 301 may continuously overheat and be subjected to thermal stress. When the electronic component 301 is overheated, performance of the electronic component 301 may deteriorate, and lifespan of the electronic component 301 may be reduced.

According to an embodiment, the thermal interface material 431 may include a phase change material (PCM). For example, the phase change material may include paraffin, salt hydrate, and/or polylactic acid (PLA)-based composite, but it is not limited thereto. For example, the thermal interface material 431 may include a matrix including rubber, the phase change material, and a heat dissipation particle (e.g., aluminum oxide (Al₂O₃)), but it is not limited thereto. At a glass transition temperature, a phase of the phase change material may change.

According to an embodiment, the thermal interface material 431 including the phase change material may be at least partially included in the shielding sheet 420. For example, the thermal interface material 431 may be penetrated into the shielding sheet 420, an interface between the shielding sheet 420 and the thermal interface material 431. Since the thermal interface material 431 is at least partially included in the shielding sheet 420), interfacial thermal resistance between the shielding sheet 420 and the thermal interface material 431 may be reduced. According to an embodiment, since heat dissipation transferred from the thermal interface material 431 to the shielding sheet 420 is improved, heat dissipation performance of the electronic device 101 may be improved.

Hereinafter, an example structure for improving heat dissipation performance will be described in greater detail below with reference to drawings.

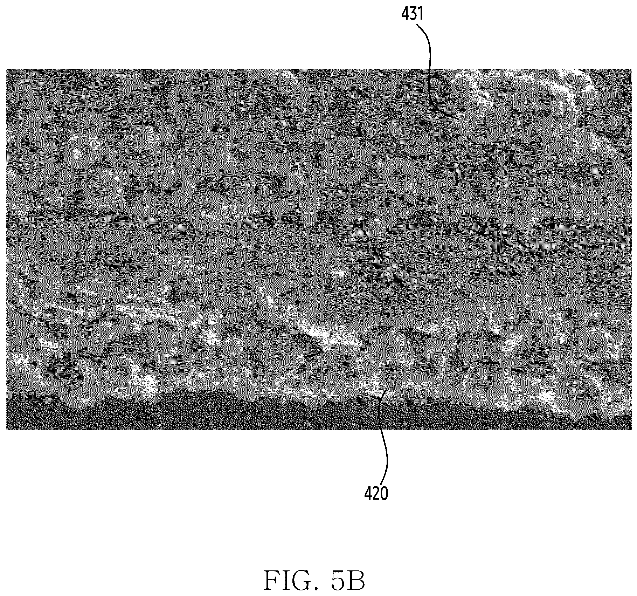

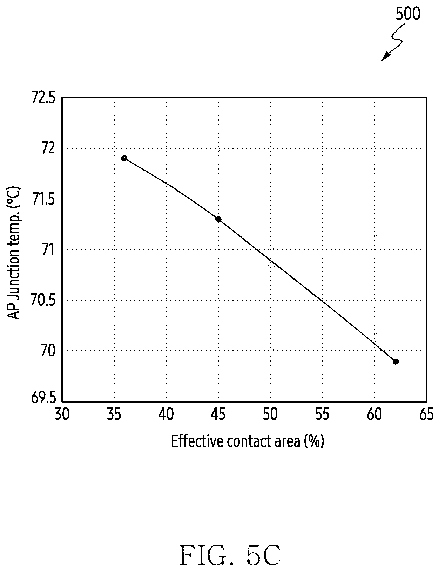

FIG. 5A is a cross-sectional view of an exemplary electronic device cut along a line A-A' of FIG. 4. FIG. 5B is a SEM photograph indicating an interface between a shielding sheet and a thermal interface material of FIG. 5A. FIG. 5C is a graph indicating a junction temperature of an electronic component in accordance with a contact area between a thermal interface material and the electronic component.

Referring to FIG. 5A, an electronic component 301 may be disposed on a printed circuit board 250. For example, the electronic component 301 may be disposed on a surface 250a of the printed circuit board 250 facing a plate 450. For example, the electronic component 301 may be connected to the printed circuit board 250 through a plurality of contact portions 251 (e.g., a solder ball), but is not limited thereto.

For example, a shield can 410 may be disposed to surround at least partially the electronic component 301. For example, the electronic component 301 may be disposed within the shield can 410 disposed on the printed circuit board 250. The shield can 410 may include a first surface 411 facing the electronic component 301 and a second surface 412 facing the first surface 411. The shield can 410 may include an opening 413 that passes through the first surface 411 and the second surface 412 and is aligned with the electronic component 301. A shielding sheet 420 may be disposed on the second surface 412 to cover the opening 413.

According to an embodiment, a thermal interface material 431 may contact the electronic component 301 and the shielding sheet 420. For example, the thermal interface material 431 may extend from a third surface 301a of the electronic component 301 facing the first surface 411 through at least a portion of the opening 413 to the shielding sheet 420. The thermal interface material 431 may be configured to transfer heat generated from the electronic component 301 to the shielding sheet 420. The heat transferred to the shielding sheet 420 through the thermal interface material 431 may be diffused to the outside of the shielding-can 410 through the shielding sheet 420.

For example, an electronic device (e.g., the electronic device 101 of FIG. 2) may include a housing 210 including a supporting member (e.g., a support) 243 and the plate 450. The plate 450 may be referred to as the first plate 202 or the second plate 211 of FIG. 2. As described with reference to FIG. 2, the supporting member 243 may extend inward from a side member (e.g., the side member 218 of FIG. 2). The supporting member 243 may be disposed inside the housing 210 and may support components of the electronic device 101. The supporting member 243 may be configured to support the printed circuit board 250. The printed circuit board 250 may be disposed on the surface 250a facing the plate 450. The shield can 410 at least partially surrounding the electronic component 301 may be disposed on the printed circuit board 250, the shielding sheet 420 may be attached to the second surface 412 of the shield can 410. The thermal interface material 431 passing through the opening 413 may be disposed between the shielding sheet 420 and the electronic component 301. For example, the shielding sheet 420 may contact the plate 450. As illustrated in FIG. 5A, the printed circuit board 250, the electronic component 301, the shield can 410, the thermal interface material 431, and the shielding sheet 420 may be disposed between the plate 450 and the supporting member 243.

In a process of assembling the housing 210, the supporting member 243 and the plate 450 may be coupled to each other. For example, the supporting member 243 may extend from a side member (e.g., the side member 218 of FIG. 2) and the plate 450 may be coupled to the side member 218. Since the supporting member 243 may extend from the side member 218, a fastening force between the plate 450 and the supporting member 243 may be generated when the plate 450 is coupled with the side member 218. The shielding sheet 420 may be pressed in a direction toward the electronic component 301 by the fastening force between the supporting member 243 and the plate 450. The fastening force may be transferred to the thermal interface material 431 through the shielding sheet 420, and the thermal interface material 431 may be pressed in a direction toward the electronic component 301. As the thermal interface material 431 is pressed toward the electronic component 301, an effective contact surface between the thermal interface material 431 and the electronic component 301 may be formed. The heat generated from the electronic component 301 may be transferred to the shielding sheet 420 through the thermal interface material 431 in contact with the electronic component 301, and may be transferred to the plate 450 through the shielding sheet 420. Since an outer surface of the plate 450 is exposed to the outside, the heat transferred to the plate 450 may be radiated to the outside of the housing 210. For example, a conduction path P for dissipating heat generated from the electronic component 301 may be formed along the electronic component 301, the thermal interface material 431, the shielding sheet 420, and/or the plate 450, but is not limited thereto.

According to an embodiment, the thermal interface material 431 may be pressed by a fastening force between the supporting member 243 and the plate 450 during an example assembly process of the electronic device 101. The printed circuit board 250 may be disposed on the supporting member 243. The electronic component 301 may be disposed on the printed circuit board 250, and the shield can 410 may be covered over the electronic component 301. The shield can 410 and a contact portion 460 of the printed circuit board 250 may have a structure for fixing the shield can 410 to the printed circuit board 250. For example, the shield can 410 may be soldered on the printed circuit board 250 or fixed on the printed circuit board 250 through an adhesive. The thermal interface material 431 may be disposed on the third surface 301a of the electronic component 301. In a state in which the thermal interface material 431 is disposed on the third surface 301a, the shielding sheet 420 for covering the opening 413 may be disposed on the second surface 412. When the plate 450 and a side member (e.g., the side member 218 of FIG. 2) are coupled after the shielding sheet 420 is disposed, a limited space may be formed between the plate 450 and the supporting member 243, and the printed circuit board 250, the shield can 410, and the shielding sheet 420 may be disposed within the limited space. Since the printed circuit board 250, the shield can 410, and the shielding sheet 420 are disposed within the limited space, the shielding sheet 420 and the printed circuit board 250 may be pressed by a fastening force between the plate 450 and the supporting member 243. The fastening force may be transferred to the thermal interface material 431 between the shielding sheet 420 and the printed circuit board 250, and the thermal interface material 431 may be pressed by the fastening force. The thermal interface material 431 may be compressed by being pressed on the third surface 301a of the electronic component 301. As the thermal interface material 431 is compressed, the thermal interface material 431 may effectively contact the shielding sheet 420 and the third surface 301a of the electronic component 301. In a compressed state, the thermal interface material 431 may effectively contact the third surface 301a of the electronic component 301 and the shielding sheet 420.

According to an embodiment, the thermal interface material 431 may include a matrix including rubber. In order for the shielding sheet 420 to transfer the heat transferred from the thermal interface material 431 to the shielding sheet 420 to the plate 450, a contact between the shielding sheet 420 and the plate 450 may be required. When the thermal interface material 431 remains a compressed state after being compressed, a portion of the shielding sheet 420 may be inserted into the opening 413. When a state in which the portion of the shielding sheet 420 is inserted into the opening 413 is maintained, since the portion of the shielding sheet 420 inserted into the opening 413 is spaced apart from the plate 450, a conduction path P for heat dissipation may not be formed. After the thermal interface material 431 in the compressed state is effectively contacted with each of the third surface 301a and shielding sheet 420 of the electronic component 301, the thermal interface material 431 may expand again due to a restoring force of the matrix including rubber. The matrix including rubber may provide a restoring force for the thermal interface material 431 in the compressed state to expand toward the plate 450. As the thermal interface material 431 is restored, the shielding sheet 420 may contact the plate 450.

When the restoring force is too strong, a portion of the shielding sheet 420 in contact with the thermal interface material 431 and the plate 450 may not be flat and may protrude. The protrusion may lower a quality of the exterior of the electronic device 101. For example, a portion of a display (e.g., the display 201 of FIG. 2) may protrude by protruding the shielding sheet 420 and the plate 450 by the thermal interface material 431. As the portion of the display 201 protrudes, a flatness of the display 201 may be reduced. For example, when the thermal interface material 431 includes a matrix including silicon, the exterior quality of the electronic device 101 may be lowered by a high restoring force of the silicon. According to an embodiment, when the thermal interface material 431 is compressed and then expanded, the thermal interface material 431 may have a low restoring force capable of contacting the shielding sheet 420 to the plate 450 without affecting the exterior quality of the electronic device 101. For example, when compressing a thermal interface material 431 having a thickness of 0.13mm with a force of 1kgf, the thermal interface material 431 may be compressed by about 30% or more. A restoring force of the thermal interface material 431 may have a low restoring force of about 1% or less. The thermal interface material 431 may not affect the exterior quality of the electronic device 101 by including the matrix including rubber.

According to an embodiment, the thermal interface material 431 may be at least partially included in the shielding sheet 420. For example, since the thermal interface material 431 penetrates at least partially within the shielding sheet 420, the thermal interface material 431 may be at least partially included in the shielding sheet 420.

For example, a thermal interface material 431 including a phase change material may be disposed on the third surface 301a of the electronic component 301 disposed in the shield can 410 in a solid phase. After the thermal interface material 431 in the solid phase state is disposed on the third surface 301a, a hot press process may be performed. For a phase change of the phase change material included in the thermal interface material 431, the hot press process may be performed at a temperature greater than or equal to a glass transition temperature of the phase change material. Through the hot press process, the phase change material included in the thermal interface material 431 may be changed to a semi-solid state (or quasi-solid state) (e.g., gel). As the phase change material changes to the semi-solid state having fluidity, at least a portion of the thermal interface material 431 may penetrate into the shielding sheet 420. In a state in which the thermal interface material 431 at least partially penetrates into the shielding sheet 420, the shielding sheet 420 and the thermal interface material 431 may be integrally formed through a post-processing process.

The thermal interface material 431 at least partially included in the shielding sheet 420 may be confirmed through scanning electron microscopy (SEM). Referring to FIG. 5B, it may be confirmed that the thermal interface material 431 is at least partially included in the shielding sheet 420, in an SEM photograph of an interface between the shielding sheet 420 and the thermal interface material 431 of FIG. 5A. Since the thermal interface material 431 penetrates from the thermal interface material 431 into the shielding sheet 420 through a fine gap at the interface between the shielding sheet 420 and the thermal interface material 431, interfacial thermal resistance between the shielding sheet 420 and the thermal interface material 431 may be reduced. For example, the thermal interface material 431 may penetrate about 5 to 7um into the shielding sheet 420, but is not limited thereto. As the interfacial thermal resistance is reduced through the thermal interface material 431 included in the shielding sheet 420, heat transfer effect from the thermal interface material 431 to the shielding sheet 420 may be improved.

Referring back to FIG. 5A, the thermal interface material 431 may contact the third surface 301a of the electronic component 301. A contact area of the third surface 301a in contact with the thermal interface material 431 may be greater than or equal to a specified ratio with respect to a total area of the third surface 301a.

When using a general thermal interface material (for example, a thermal interface material not including a phase change material), the shielding sheet may include layers (e.g., nanofiber sheets) having different densities to improve heat dissipation performance. For example, the shielding sheet may include a high-density layer having a first density and a low-density layer having a second density lower than the first density. For example, the high-density layer may contact the thermal interface material, and the low-density layer may contact the plate 450. When applying a general liquid thermal interface material to the electronic component 301, an oil bleeding phenomenon in which oil flows may occur due to a difference in density between the low-density layer and the high-density layer of the shielding sheet. A separate structure (e.g., DAM) may be required to prevent and/or reduce oil from flowing to the shielding sheet. When the separate structure is included, an effective contact area for applying a thermal interface material to the third surface 301a of the electronic component 301 may be reduced. A decrease in the effective contact area may cause a decrease in heat dissipation performance.

According to an embodiment, since the thermal interface material 431 is at least partially included in the shielding sheet 420, the shielding sheet 420 and the thermal interface material 431 may be integrally formed. In case that the shielding sheet 420 and the thermal interface material 431 are integrally formed, since an interfacial thermal resistance between the shielding sheet 420 and the thermal interface material 431 is low even when layers forming the shielding sheet 420 do not have different densities, heat dissipation performance may be high. According to an embodiment, since layers having different densities are not included in the shielding sheet 420, a structure for preventing/reducing oil from flowing may not be required. Since a separate structure is not required, a contact area between the thermal interface material 431 and the electronic component 301 may be secured. For example, the thermal interface material 431 may be greater than or equal to about 60% of the total area of the third surface 301a, but is not limited thereto.

A graph 500 illustrated in FIG. 5C illustrates a change in a junction temperature of the electronic component 301 according to the contact area between the thermal interface material 431 and the electronic component 301. The x-axis of the graph 500 indicates a ratio (unit: percent (%)) of an area in contact with the thermal interface material 431 with respect to the total area of the electronic component 301. The y-axis of the graph 500 indicates a junction temperature (unit: °C) of the electronic component 301.

Referring to the graph 500 illustrated in FIG. 5C, when the contact area between the thermal interface material 431 and the electronic component 301 increases, the junction temperature of the electronic component 301 may decrease. For example, when the contact area increases from about 35% to about 60% or more, the junction temperature may be lowered from about 72°C to about 70°C. For example, the contact area between the thermal interface material 431 and the electronic component 301 may be about 60% greater than or equal to the total area of the electronic component 301. For example, the total area of the third surface 301a of the electronic component 301 may be about 174.00mm², and the area of the third surface 301a in contact with the thermal interface material 431 may be about 108.9mm². In the above-described case, the contact area between the thermal interface material 431 and the electronic component 301 may be about 62.5% of the total area of the electronic component 301. Since an area capable of contacting the thermal interface material 431 to the electronic component 301 may be secured a specified ratio or more, heat dissipation performance of the electronic device 101 may be improved.

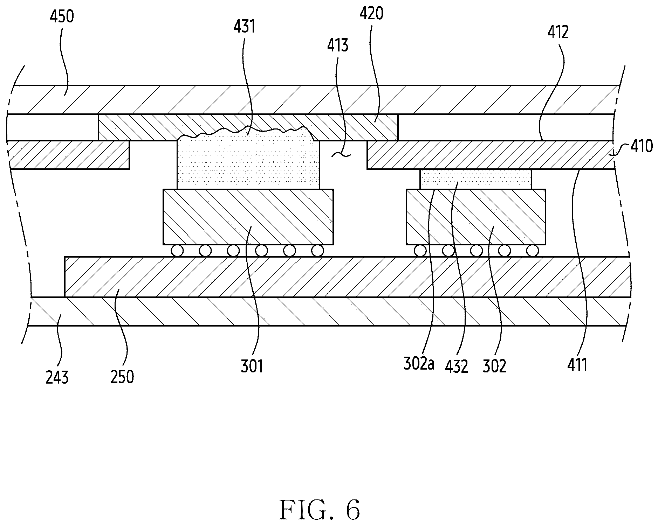

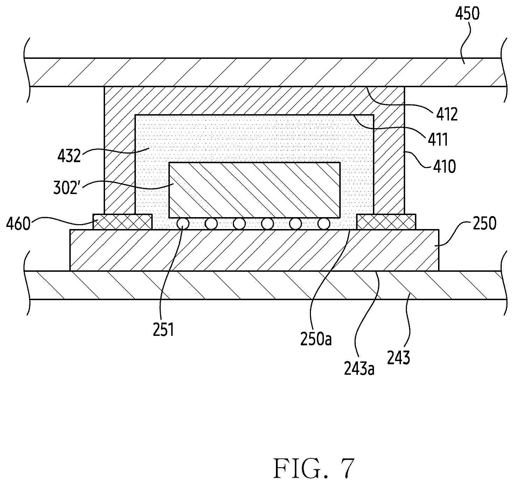

FIG. 6 is a cross-sectional view of an exemplary electronic device cut along line B-B' of FIG. 4. FIG. 7 is a cross-sectional view of an exemplary electronic device cut along line C-C' of FIG. 4.

Referring to FIG. 6, a plurality of electronic components 301 and 302 may be disposed on a printed circuit board 250. For example, an electronic device 101 may include a first electronic component 301 and a second electronic component 302 spaced apart from each other on the printed circuit board 250. The first electronic component 301 may be referred to as an electronic component having a relatively large amount of heat generated according to operation. The first electronic component 301 may include a semiconductor including an integrated circuit (IC). For example, the first electronic component 301 may include an application processor (AP) (e.g., the processor 120 of FIG. 1), a memory (e.g., a dynamic random access memory (DRAM)), and/or a charging IC. For example, the second electronic component 302 may be referred to as an electronic component having a relatively small amount of heat generated by the operation. For example, the second electronic component 302 may include a speaker (e.g., the sound output module 155 of FIG. 1). However, it is not limited thereto.

For example, when the first electronic component 301 and the second electronic component 302 operate, heat generated from the first electronic component 301 may be greater than heat generated from the second electronic component 302. A shield can 410 may include an opening 413 aligned with the first electronic component 301 so that the heat generated from the first electronic component 301 may be transferred to the outside of the shield can 410. For example, the opening 413 may be aligned with the first electronic component 301. Since the amount of heat generated from the second electronic component 302 is relatively small, the shield can 410 may not include an opening for the second electronic component 302.

According to an embodiment, the shielding sheet 420 may cover the opening 413. The shielding sheet 420 may be configured to shield inflow and/or outflow of an electromagnetic wave through the opening 413, by covering the opening 413. The shielding sheet 420 covering the opening 413 may be overlapped the first electronic component 301. Since the opening 413 is aligned with a cover, the shielding sheet 420 may be configured to shield an electromagnetic wave flowing out of the shield can 410 through the opening 413, and shield an electromagnetic wave flowing into the shield can 410 through the opening 413 from the outside of the shield can 410. The cover may have an area larger than an area of the opening 413 to cover the opening 413. Since the shield can 410 does not include an opening for the second electronic component 302, the shielding sheet 420 may not be disposed on a portion of the shield can 410 facing the second electronic component 302 spaced apart from the first electronic component 301.

For example, the electronic device 101 may further include a second thermal interface material 432 for the second electronic component 302. The thermal interface material 432 in contact with the first electronic component 301 may be referred to as a first interface material 431. The second thermal interface material 432 may be in contact with each of the second electronic component 302 and the shield can 410. For example, the second thermal interface material 431 may extend from a fourth surface 302a of the second electronic component 302 facing a first surface 411 to the first surface 411 of the shield can 410. Heat generated when the second electronic component 302 operates may be transferred to the shield can 410 through the second thermal interface material 431. The heat transferred to the shield can 410 may be radiated to the outside of the shield can 410 through the shield can 410. The second thermal interface material 432 may be distinguished from the first thermal interface material 431. For example, the first thermal interface material 431 may include a phase change material to be included in the shielding sheet 420 in contact through at least a portion of the opening 413. Since the second thermal interface material 432 does not contact the shielding sheet 420, the second thermal interface material 432 may not include a phase change material.

For example, at least a portion of an electronic component 302' spaced apart from the first electronic component 301 aligned with the opening 413 may be surrounded by the second thermal interface material 432. Referring to FIG. 7, a third electronic component 302' spaced apart from the first electronic component 301 may be surrounded by the second thermal interface material 432 in the shield can 410. For example, the shield can 410 may not include an opening 413 for the third electronic component 302'. The second thermal interface material 432 may be disposed to surround the third electronic component 302'. For example, the second thermal interface material 432 may be filled in a space between the shield can 410 and the third electronic component 302' to surround the third electronic component 302' disposed in the shield can 410. Since the second thermal interface material 432 is disposed to entirely surround the third electronic component 302', heat generated from the third electronic component 302' may be easily transferred to the shield can 410. Since a contact area between the second thermal interface material 432 and the third electronic component 302' is large, heat dissipation performance may be improved.

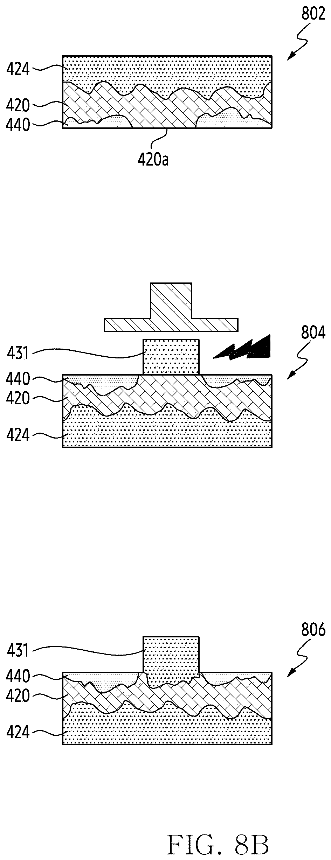

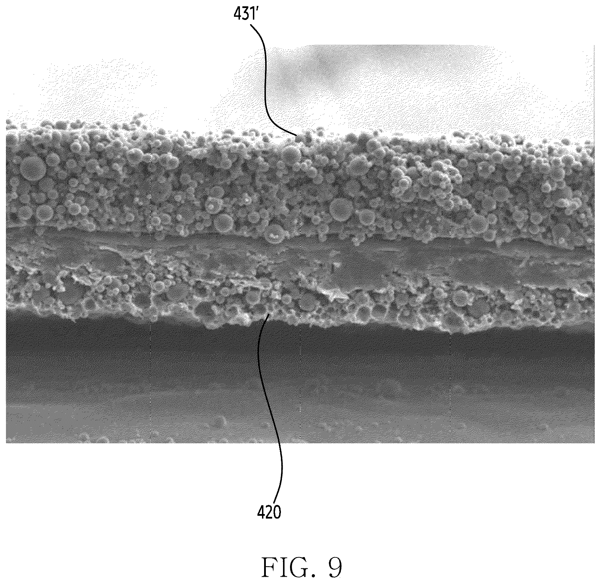

FIG. 8A schematically illustrates a process of manufacturing a thermal interface material and a shielding sheet according to a comparative example. FIG. 8B schematically illustrates an exemplary process of manufacturing a thermal interface material and a shielding sheet. FIG. 9 is a SEM photograph indicating an interface between a shielding sheet and a thermal interface material manufactured through a manufacturing process of FIG. 8A.

According to a comparative example illustrated in FIG. 8A, in 801 of FIG. 8A, an adhesive member 440 may be coated on a surface of a shielding sheet 420. The surface of the shielding sheet 420 may be a surface facing an electronic component (e.g., the electronic component 301 of FIG. 5A). The adhesive member 440 may be entirely coated on the surface of the shielding sheet 420. A heat dissipation layer for heat dissipation may be formed on another surface of the shielding sheet 420. For example, the heat dissipation layer may be referred to as another thermal interface material 424 not including a phase change material. In 803 of FIG. 8A, a thermal interface material 431' may be in contact with the adhesive member 440 coated on the shielding sheet 420. For example, the thermal interface material 431' and the shielding sheet 420 may be in contact with each other, by a fastening force between a plate (e.g., the plate 450 of FIG. 5A) and a supporting member (e.g., the supporting member 243 of FIG. 5A). 805 of FIG. 8A illustrates a state in which the shielding sheet 420 and the thermal interface material 431' are in contact with each other. The thermal interface material 431' may be attached to the shielding sheet 420 by the adhesive member 440. A portion of the adhesive member 440 that does not contact the thermal interface material 431' may provide adhesion between the shielding sheet 420 and the shield can 410, by being attached to a second surface (e.g., the second surface 412 of FIG. 5A) of the shield can (e.g., the shield can 410 of FIG. 5A). Since the thermal interface material 431' and the shielding sheet 420 include different materials, interfacial thermal resistance between the shielding sheet 420 and the thermal interface material 431' may be relatively high.

Referring to FIG. 8B, in 802 of FIG. 8B, the adhesive member 440 may be coated on a surface of the shielding sheet 420. The adhesive member 440 may not be entirely coated on the surface of the shielding sheet 420, but may be coated on only a remaining area except for a partial area 420a. For example, the adhesive member 440 may be coated in the remaining area except for the area 420a for the thermal interface material 431 to be included in the shielding sheet 420.

In FIG. 8B, a hot press process may be performed such that the thermal interface material 431 is included in the shielding sheet 420 through the area. For example, the thermal interface material 431 may include a phase change material. The hot press process may be performed at a temperature greater than or equal to a glass transition temperature of the phase change material. For example, when the glass transition temperature of the phase change material is about 40°C, the thermal interface material 431 may be phase-changed from a solid phase to a semi-solid state (e.g., gel) at a temperature greater than or equal to about 40°C. Since it is easier for the thermal interface material 431 to penetrate into the shielding sheet 420 when fluidity of the thermal interface material 431 is higher, the hot press process may be performed at a temperature sufficiently higher than the glass transition temperature, in order to secure penetration of the thermal interface material 431. For example, the hot press process may be performed at a temperature of about 90°C or higher. For example, the hot press process may include a thermal compression roll-to-roll processing, but it is not limited thereto. In the hot press process, the thermal interface material 431 may firmly contact an electronic component (e.g., electronic component 301 of FIG. 5A) by changing to a soft semi-solid state. For example, since the soft thermal interface material 431 may fill a fine gap between the thermal interface material 431 and a third surface (e.g., the third surface 301a of FIG. 5A) of the electronic component 301, the thermal interface material 431 may be firmly in contact with the electronic component 301. As the thermal interface material 431 is firmly in contact with the electronic component 301, heat transfer from the electronic component 301 to the thermal interface material 431 may be smoothly performed.

FIG. 8B illustrates a state 806 in which the thermal interface material 431 is included in the shielding sheet 420. For example, in the hot press process, at least a portion of the thermal interface material 431 in a solid state may be phase-changed. The thermal interface material 431 may at least partially penetrate into the shielding sheet 420 through a gap formed at an interface between the shielding sheet 420 and the thermal interface material 431 in a phase-changed state. Since the thermal interface material 431 is at least partially included in the shielding sheet 420, the interfacial thermal resistance between the shielding sheet 420 and the thermal interface material 431 may be relatively low.

Referring to FIG. 9, a gap may be formed at an interface between the shielding sheet 420 and the thermal interface material 431' according to a comparative example. For example, a gap may be formed according to roughness of a surface of the shielding sheet 420 and a surface of the thermal interface material 431'. Since air may exist in the interface, heat transferred from the thermal interface material 431' to the shielding sheet 420 may be affected by a low thermal conductivity of the air. Since air has relatively low thermal conductivity, interfacial thermal resistance between the thermal interface material 431' and the shielding sheet 420 may be relatively high. Since heat dissipation performance of the electronic device 101 may be deteriorated when the interfacial thermal resistance is high, a separate cooling structure (e.g., a heat pipe, a vapor chamber) for heat dissipation may be additionally required.

Referring back to FIG. 5B, according to an embodiment, the thermal interface material 431 may be at least partially included in the shielding sheet 420. As the thermal interface material 431 at least partially penetrates into the shielding sheet 420, the shielding sheet 420 and the thermal interface material 431 may be integrally formed. According to an embodiment, since the thermal interface material 431 is at least partially included in the shielding sheet 420, the interfacial heat resistance between the shielding sheet 420 and the thermal interface material 431 may be reduced. According to an embodiment, since a separate structure (e.g., DAM) for oil bleeding phenomenon is not required, a contact area between the electronic component 301 and the thermal interface material 431 may be easily secured.

Table 1 below illustrates an experimental result of evaluating heat dissipation performance of an electronic device having a heat dissipation structure formed according to a manufacturing process illustrated in FIG. 8A and an electronic device 101 having a heat dissipation structure formed according to a manufacturing process illustrated in FIG. 8B. Power of 3.6W was applied to the electronic component 301, and then a temperature of a surface of the electronic component 301 is measured 15 minutes later.

**[Table 1]**

| Classification | Temperature (°C) |
|---|---|
| Comparison example | 58.45 |
| Experimental example | 55.75 |

Referring to Table 1, since an experimental example having an integrated structure of the thermal interface material 431 and the shielding sheet 420 has temperature about 2.7°C lower than a comparative example, it may be confirmed that the experimental example has enhanced heat dissipation performance. According to an embodiment, the electronic device 101 may reduce functional degradation and lifespan reduction due to temperature increase, by effectively radiating heat generated from the electronic component 301. According to an embodiment, as the shielding sheet 420 and the heat dissipation sheet are integrally formed, the electronic device 101 may have a simple manufacturing process and the manufacturing time may be reduced.

FIG. 10 schematically illustrates an exemplary shielding sheet.

Referring to FIG. 10, a shielding sheet 420 may include a plurality of layers 421, 422, and 423. For example, the shielding sheet 420 may include a first layer 421, a second layer 422, and a third layer 423 sequentially stacked, but is not limited thereto.

For example, the first layer 421 may be attached to a shield can (e.g., the shield can 410 of FIG. 5A). For example, the first layer 421 may be attached to a second surface (e.g., the second surface 412 of FIG. 5A) of the shield can 410 through an adhesive member 440. The adhesive member 440 may be disposed between a surface (e.g., the lower surface) of the first layer 421 facing an electronic component (e.g., the electronic component 301 of FIG. 5A) and a second surface (e.g., the second surface 412 of FIG. 5A) of the shield can 410. The adhesive member 440 may be in contact with a remaining area of the first layer 421 excluding an area 420a for penetrating into the shielding sheet 420 by the thermal interface material 431, among the surface of the first layer 421. For example, the adhesive member 440 may include a pressure sensitive adhesive (PSA), but it is not limited thereto. The thermal interface material 431 may be included in the shielding sheet 420 through the first layer 421. Heat generated from the electronic component 301 may be transferred to the first layer 421 through the thermal interface material 431. Since the thermal interface material 431 is included in the first layer 421 of the shielding sheet 420, interfacial thermal resistance between the thermal interface material 431 and the shielding sheet 420 may be lowered.

The second layer 422 may be disposed on the first layer 421. The second layer 422 may be configured to diffuse the heat transferred from the first layer 421. For example, the second layer 422 may include graphite 425 for heat diffusion and/or a heat radiating filler 426 filled in a binder.

For example, the third layer 423 may be disposed on the second layer 422. The third layer 423 may be configured to radiate the heat transferred from the second layer 422 to the outside of the shielding sheet 420. The third layer 423 may be referred to as a heat dissipation layer. The third layer 423 may be referred to as another thermal interface material 424. Through the other thermal interface material 424, heat may be radiated to the outside of the shielding sheet 420.

For example, the first layer 421, the second layer 422, and/or the third layer 423 may be referred to as a shielding layer for electromagnetic wave shielding. For example, the first layer 421, the second layer 422, and/or the third layer 423 may include carbon black 427 for electromagnetic wave shielding, but is not limited thereto.

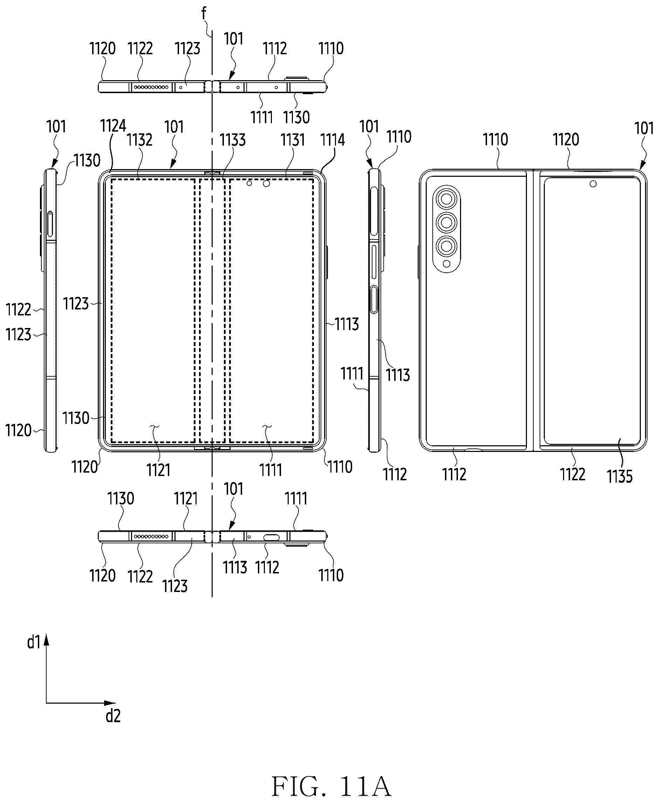

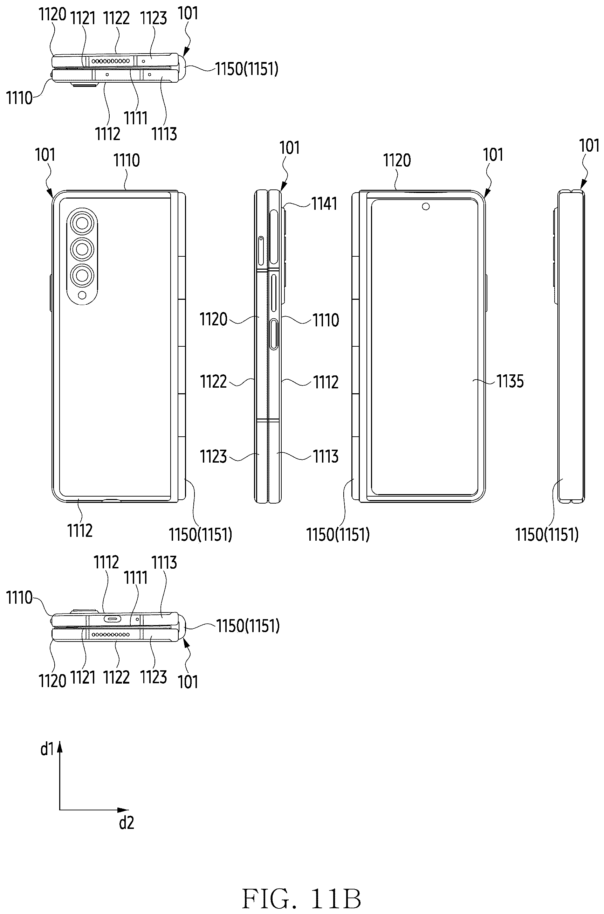

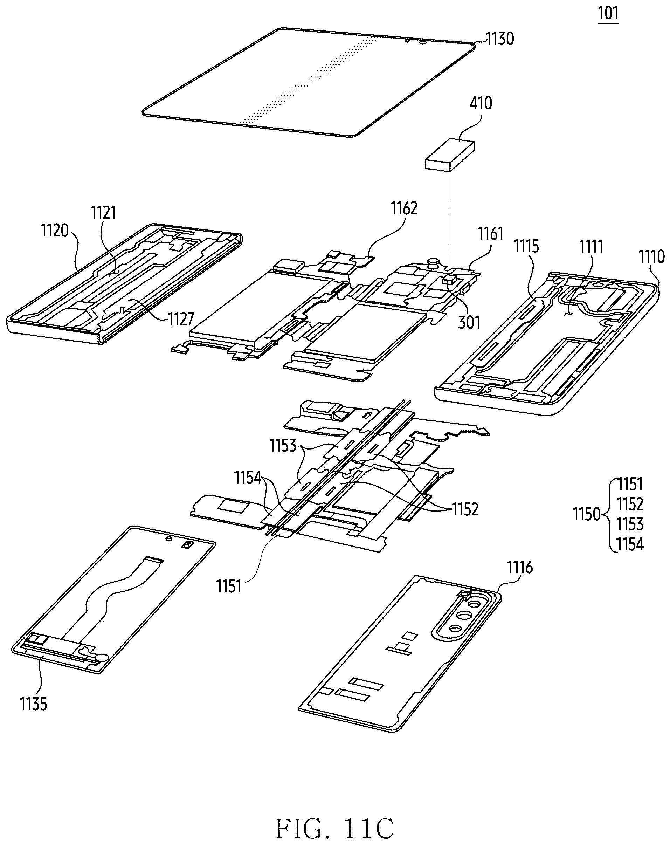

FIG. 11A illustrates an example of an unfolding state of an electronic device, according to an embodiment. FIG. 11B illustrates an example of a folding state of an electronic device, according to an embodiment. FIG. 11C is an exploded perspective view of an electronic device according to an embodiment.

Referring to FIGS. 11A, 11B, and 11C, an electronic device 101 may include a first housing 1110, a second housing 1120, a flexible display 1130, and/or a hinge structure 1150.

According to an embodiment, the first housing 1110 and the second housing 1120 may form at least a portion of an outer surface of the electronic device 101 capable of being gripped by a user. According to an embodiment, the first housing 1110 may include a first surface 1111, a second surface 1112 facing the first surface 1111 and spaced apart from the first surface 1111, and a first side surface 1113 surrounding at least a portion of the first surface 1111 and the second surface 1112. The first side surface 1113 may connect a periphery of the first surface 1111 to a periphery of the second surface 1112. The first surface 1111, the second surface 1112, and the first side surface 1113 may form an inner space of the first housing 1110. According to an embodiment, the first housing 1110 may provide a space formed by the first surface 1111, the second surface 1112, and the first side surface 1113 as a space for arranging components of the electronic device 101.

According to an embodiment, the second housing 1120 may include a third surface 1121, a fourth surface 1122 facing the third surface 1121 and spaced apart from the third surface 1121, and a second side surface 1123 surrounding at least a portion of the third surface 1121 and the fourth surface 1122. The second side surface 1123 may connect a periphery of the third surface 1121 and a periphery of the fourth surface 1122. The third surface 1121, the fourth surface 1122 and the second side surface 1123 may form an inner space of the second housing 1120. According to an embodiment, the second housing 1120 may provide a space formed by the third surface 1121, the fourth surface 1122, and the second side surface 1123 surrounding at least a portion of the third surface 1121 and the fourth surface 1122 as a space for mounting components of the electronic device 101. According to an embodiment, the second housing 1120 may be rotatably coupled to the first housing 1110 with respect to the first housing 1110.

According to an embodiment, the first housing 1110 may include a first side member 1114 forming the first side surface 1113, and the second housing 1120 may include a second side member 1124 forming the second side surface 1123. For example, the first side member 1114 may surround at least a portion of a periphery of a first display area 1131 of the flexible display 1130, and the second side member 1124 may surround at least a portion of a periphery of a second display area 1132 of the flexible display 1130.

According to an embodiment, the flexible display 1130 may be configured to display visual information. According to an embodiment, the flexible display 1130 may be disposed on the first surface 1111 of the first housing 1110 and the third surface 1121 of the second housing 1120, across the hinge structure 1150. For example, the flexible display 1130 may include the first display area 1131 disposed on the first surface 1111 of the first housing, the second display area 1132 disposed on the third surface 1121 of the second housing, and a third display area 1133 disposed between the first display area 1131 and the second display area 1132. For example, the first display area 1131, the second display area 1132, and the third display area 1133 may form a front surface of the flexible display 1130. According to an embodiment, the flexible display 1130 may further include a sub-display panel 1135 disposed on the fourth surface 1122 of the second housing 1120. According to an embodiment, the flexible display 1130 may include a window exposed to the outside of the electronic device 101. The window may protect a surface of the flexible display 1130, and transfer visual information provided by the flexible display 1130 to the outside of the electronic device 101 by including a substantially transparent material. For example, the window may include glass (e.g., ultra-thin glass (UTG)) and/or polymer (e.g., polyimide (PI)), but it is not limited thereto.

According to an embodiment, the hinge structure 1150 may rotatably connect the first housing 1110 and the second housing 1120. The hinge structure 1150 may be disposed between the first housing 1110 and the second housing 1120 of the electronic device 101 so that the electronic device 101 may be bent, curved, or folded. For example, the hinge structure 1150 may be disposed between a portion of the first side surface 1113 and a portion of the second side surface 1123, which face each other. The hinge structure 1150 may change the electronic device 101 to an unfolding state in which the first surface 1111 of the first housing 1110 and the third surface 1121 of the second housing 1120 face the same direction or a folding state in which the first surface 1111 and the third surface 1121 face each other. When the electronic device 101 is in the folding state, the first housing 1110 and the second housing 1120 may be stacked or overlapped, by facing each other.

According to an embodiment, when the electronic device 101 is in the folding state, a direction in which the first surface 1111 faces and a direction in which the third surface 1121 faces may be different from each other. For example, when the electronic device 101 is in the folding state, the direction in which the first surface 1111 faces and the direction in which the third surface 1121 faces may be opposite to each other. For another example, when the electronic device 101 is in the folding state, the direction in which the first surface 1111 faces and the direction in which the third surface 1121 faces may be inclined with respect to each other. When the direction in which the first surface 1111 faces is inclined with respect to the direction in which the third surface 1121 faces, the first housing 1110 may be inclined with respect to the second housing 1120.

According to an embodiment, the electronic device 101 may be foldable with respect to a folding axis f. The folding axis f may refer to a virtual line extending through a hinge cover 1151 in a direction (e.g., d1 in FIGS. 11A and 11B) parallel to a longitudinal direction of the electronic device 101, but it is not limited thereto. For example, the folding axis f may be a virtual line extending in a direction (e.g., d2 in FIGS. 11A and 11B) perpendicular to the longitudinal direction of the electronic device 101. When the folding axis f extends in the direction perpendicular to the longitudinal direction of the electronic device 101, the hinge structure 1150 may connect the first housing 1110 with the second housing 1120 by extending in the direction parallel to the folding axis f. The first housing 1110 and the second housing 1120 may be rotatable by the hinge structure 1150 extending in the direction perpendicular to the longitudinal direction of the electronic device 101.

According to an embodiment, the hinge structure 1150 may include the hinge cover 1151, a first hinge plate 1152, a second hinge plate 1153, and a hinge module 1154. The hinge cover 1151 may surround internal components of the hinge structure 1150 and form an outer surface of the hinge structure 1150. According to an embodiment, when the electronic device 101 is in the folding state, the hinge cover 1151 surrounding the hinge structure 1150 may be at least partially exposed to the outside of the electronic device 101 through a space between the first housing 1110 and the second housing 1120. According to an embodiment, when the electronic device 101 is in the unfolding state, the hinge cover 1151 may not be exposed to the outside of the electronic device 101 by being covered by the first housing 1110 and the second housing 1120.

According to an embodiment, the first hinge plate 1152 and the second hinge plate 1153 may rotatably connect the first housing 1110 and the second housing 1120, by being coupled to the first housing 1110 and the second housing 1120, respectively. For example, the first hinge plate 1152 may be coupled to a first supporting member 1115 of the first housing 1110, and the second hinge plate 1153 may be coupled to a second supporting member 1127 of the second housing 1120. As the first hinge plate 1152 and the second hinge plate 1153 are coupled to the first supporting member 1115 and the second supporting member 1127, respectively, the first housing 1110 and the second housing 1120 may be rotatable according to a rotation of the first hinge plate 1152 and the second hinge plate 1153.

The hinge module 1154 may rotate the first hinge plate 1152 and the second hinge plate 1153. For example, the hinge module 1154 may rotate the first hinge plate 1152 and the second hinge plate 1153 with respect to the folding axis f, by including gears capable of being engaged each other and rotatable. According to an embodiment, the number of the hinge modules 1154 may be plural. For example, the plurality of the hinge modules 1154 may be disposed to be spaced apart from each other, at both ends of the first hinge plate 1152 and the second hinge plate 1153, respectively.

According to an embodiment, the first housing 1110 may include the first supporting member 1115 and a first cover 1116, and the second housing 1120 may include the second supporting member 1127. The first supporting member 1115 may be disposed inside the first housing 1110 and may support components of the electronic device 101. The first cover 1116 may cover the second surface 1112 of the first housing 1110. The second supporting member 1127 may be disposed inside the second housing 1120 and may support components of the electronic device 101. The sub-display panel 1135 may be disposed on the fourth surface 1122 of the second housing 1120.

According to an embodiment, a portion of the first supporting member 1115 may be surrounded by the first side surface 1113, and a portion of the second supporting member 1127 may be surrounded by the second side surface 1123. For example, the first supporting member 1115 may be integrally formed with the first side surface 1113, and the second supporting member 1127 may be integrally formed with the second side surface 1123. For another example, the first supporting member 1115 may be formed separately from the first side surface 1113, and the second supporting member 1127 may be formed separately from the second side surface 1123.

According to an embodiment, the electronic component 301 may be disposed on a first printed circuit board 1161 or a second printed circuit board 1162. An electronic component 301, a shield can 410, a shielding sheet 420, and a thermal interface material 431 illustrated in FIG. 11C may be substantially the same as the electronic components 301, the shield can 410, the shielding sheet 420, and the thermal interface material 431 described above. For example, referring to FIG. 11C, the electronic device 101 may include the electronic component 301, the shield can 410, the shielding sheet 420, and the thermal interface material 431. The electronic component 301 may be disposed on the first printed circuit board 1161. The shield can 410 may at least partially surround the electronic component 301. For example, the thermal interface material 431 may be configured to transfer heat generated from the electronic component 301 to the shielding sheet 420. For example, the thermal interface material 431 may be in contact with each of the electronic component 301 and the shielding sheet 420. For example, the thermal interface material 431 may extend from the electronic component 301 to the shielding sheet 420 through at least a portion of the opening 413. Redundant descriptions are omitted.

According to an embodiment, the thermal interface material 431 may transfer heat generated from the electronic component 301 to the shielding sheet 420. The thermal interface material 431 may reduce deterioration of the exterior quality of the electronic device 101 by having a low restoring force. For example, the flexible display 1130 may have a thin thickness, by including the third display area 1133, which is a flexible area capable of being bent. When a restoring force of the thermal interface material 431 is strong, some areas of the flexible display 1130 may be not flat and may be rugged, by expanding toward the flexible display 1130. For example, since the thermal interface material 431 has a low restoring force when expanding after being compressed, an influence on flatness of the flexible display 1130 disposed on the electronic component 301 may be reduced.

According to an example embodiment, an electronic device (e.g., the electronic device 101 of FIG. 5A) may include: an electronic component (e.g., the electronic component 301 of FIG. 5A), a shield can (e.g., the shield can 410 of FIG. 5A), a shielding sheet (e.g., the shielding sheet 420 of FIG. 5A), and a thermal interface material (e.g., the thermal interface material 430 of FIG. 5A). The electronic component may be disposed on a printed circuit board (e.g., the printed circuit board 250 of FIG. 5A). The shield can may at least partially surround the electronic component. The shield can may be disposed on the printed circuit board. The shield can may include a first surface (e.g., the first surface 411 of FIG. 5A), a second surface (e.g., the second surface 412 of FIG. 5A), and an opening (e.g., the opening 413 of FIG. 5A). The first surface may face the electronic component. The second surface may face the first surface. The opening may pass through the first surface and the second surface. The opening may be aligned with the electronic component. The shielding sheet may be disposed on the second surface of the shield can to cover the opening of the shield can. The thermal interface material may be configured to transfer heat generated from the electronic component to the shielding sheet. The thermal interface material may extend from a third surface (e.g., the third surface 301a of FIG. 5A) facing the first surface of the electronic component to the shielding sheet through at least a portion of the opening. The thermal interface material may include a phase change material (PCM). The thermal interface material may be at least partially included in the shielding sheet. According to an example embodiment, since the thermal interface material penetrates into the shielding sheet through an interface between the shielding sheet and the thermal interface material, interfacial thermal resistance between the shielding sheet and the thermal interface material may be reduced. According to an example embodiment, since heat dissipation transferred from the thermal interface material to the shielding sheet is improved, heat dissipation performance of the electronic device may be improved.

According to an example embodiment, the thermal interface material may be at least partially penetrated into the shielding sheet.

According to an example embodiment, the thermal interface material may be at least partially penetrated into the shielding sheet, through a gap between the thermal interface material and the shielding sheet, by being heat-compressed at a temperature higher than a glass transition temperature of the phase change material. According to an example embodiment based on a thermal interface material in a solid state being disposed on the electronic component, a hot press process may be performed. As the hot press process is performed at a temperature greater than or equal to the glass transition temperature, a phase change material may change into a semi-solid state (e.g., gel). As fluidity of the phase change material increases, at least a portion of the thermal interface material may penetrate into the shielding sheet.

According to an example embodiment, the thermal interface material may contact the third surface of the electronic component. An area of the third surface in contact with the thermal interface material may be greater than or equal to a specified ratio with respect to the total area of the third surface. According to an example embodiment, since a separate structure (e.g., DAM) is not required, a contact area between the thermal interface material and the electronic component may be secured. For example, the specified ratio may be about 60%, but is not limited thereto.

According to an example embodiment, the electronic device may further include a housing including a supporting member comprising a support (e.g., the supporting member 243 of FIG. 5A) configured to support the printed circuit board and a plate (e.g., the plate 450 of FIG. 5A) disposed on the shielding sheet.

According to an example embodiment, the thermal interface material may be configured to be compressed by being pressed by a fastening force between the supporting member and the plate. According to an example embodiment, based on a side member and the plate being coupled, the thermal interface material may be pressed in a direction toward the electronic component by the fastening force between the supporting member and the plate. As the thermal interface material is compressed, the thermal interface material may be effectively in contact with the shielding sheet and the third surface of the electronic component.

According to an example embodiment, the thermal interface material may further comprise a matrix comprising rubber configured to provide a restoring force to expand toward the plate in a compressed state. According to an example embodiment, a restoring force of the thermal interface material may have a low restoring force less than or equal to about 1%. The thermal interface material may not affect the exterior quality of the electronic device by including the matrix including rubber.

According to an example embodiment, the thermal interface material may be formed integrally with the shielding sheet.

According to an example embodiment, the electronic device may further include a second electronic component (e.g., the second electronic component 302 of FIG. 6) and a second thermal interface material (e.g., the second thermal interface material 432 of FIG. 6). The second electronic component may be spaced apart from the electronic component, which is a first electronic component, on the printed circuit board. The second electronic component may be at least partially surrounded by the shield can. The second thermal interface material may be configured to transfer heat generated from the second electronic component to the shield can. The second thermal interface material may be distinguished from the thermal interface material, which is a first thermal interface material. The second thermal interface material may fill a space between the shield can and the second electronic component. According to an example embodiment, based on the second electronic component having relatively low heat generation, the shield can may not include an opening for the second electronic component. Since the second thermal interface material for heat dissipation of the electronic component does not need to be included in the shielding sheet, a phase change material may not be included. The second thermal interface material may fill a space between the shield can and the second electronic component to improve heat dissipation performance.

According to an example embodiment, the shielding sheet may be attached to the second surface through an adhesive member comprising an adhesive (e.g., the adhesive member 440 of FIG. 5A) between the second surface and the shielding sheet. According to an example embodiment, the adhesive member may attach the shielding sheet to the shield can. The adhesive member may be in contact with a remaining area of the shielding sheet except for some areas for penetrating of the thermal interface material.

According to an example embodiment, the shielding sheet may include a first layer (e.g., the first layer 421 of FIG. 10), a second layer (e.g., the second layer 422 of FIG. 10), and a third layer (e.g., the third layer 423 of FIG. 10). The first layer may be attached to the second surface through an adhesive member. The first layer may include another thermal interface material (e.g., the other thermal interface material 424 of FIG. 10) distinct from the thermal interface material. The second layer may be disposed on the first layer. The second layer may be configured to diffuse heat transferred from the first layer. The third layer may be disposed on the second layer. The third layer may be configured to radiate heat transferred from the second layer to the outside of the shielding sheet. According to an example embodiment, heat transferred from the thermal interface material may be radiated to the outside through the shielding sheet.

According to an example embodiment, the first layer and the second layer may be configured to shield a noise signal generated from the electronic component. According to an example embodiment of the present disclosure, the shielding sheet may reduce mutual interference by the noise signal, by shielding an electromagnetic wave.

According to an example embodiment, the electronic component may include at least one of a processor, a charging circuit, or a memory.

According to an example embodiment, the electronic device may further include a first housing (e.g., the first housing 1110 of FIG. 11A), a second housing (e.g., the second housing 1120 of FIG. 11A), and a flexible display (e.g., the flexible display 1130 of FIG. 11A). The second housing may be rotatably coupled to the first housing with respect to the folding axis. The flexible display may include a folding area (e.g., the third display area 1133 of FIG. 11A) that is deformed based on the second housing being rotated with respect to the first housing.

According to an example embodiment, the phase change material may include at least one of paraffin, salt hydrate, or polylactic acid (PLA)-based composite.

According to an example embodiment, an electronic device may include a housing, a display, an electronic component, a shield can, a shielding sheet, and a thermal interface material. The housing may include a first plate (e.g., the first plate 202 of FIG. 3), a second plate (e.g., the second plate 211 of FIG. 3), and a supporting member comprising a support. The second plate may be opposite to the first plate. The supporting member may be disposed between the first plate and the second plate. The display may be disposed between the supporting member and the first plate. The electronic component may be disposed on a surface of the supporting member facing the first plate. The shield can may at least partially surround the electronic component. The shield can may be disposed on the surface of the printed circuit board. The shield can may include a first surface, a second surface, and an opening. The first surface may face the electronic component. The second surface may face the first surface. The opening may pass through the first surface and the second surface. The opening may be aligned with the electronic component. The shielding sheet may be disposed on the second surface of the shield can to cover the opening of the shield can. The thermal interface material may be configured to transfer heat generated from the electronic component to the shielding sheet. The thermal interface material may extend from a third surface of the electronic component facing the first surface to the shielding sheet through at least a portion of the opening. The thermal interface material may include a phase change material (PCM). The thermal interface material may be at least partially included in the shielding sheet.

According to an example embodiment, the thermal interface material may at least partially penetrate the shielding sheet, through a gap between the thermal interface material and the shielding sheet, by being heat-compressed at a temperature higher than a glass transition temperature of the phase change material.

According to an example embodiment, the thermal interface material may contact the third surface of the electronic component. An area of the third surface in contact with the thermal interface material may be greater than or equal to a specified ratio with respect to the total area of the third surface.

According to an example embodiment, the thermal interface material may further comprise rubber configured to provide a restoring force to restore toward the first plate in a state compressed by being pressed by a fastening force between the supporting member and the first plate.

According to an example embodiment, the housing may include a first housing and a second housing. The second housing may be rotatably coupled to the first housing with respect to the folding axis. The electronic device may further include a flexible display. The flexible display may include a first display area (e.g., the first display area 1131 of FIG. 11A), a second display area (e.g., the second display area 1132 of FIG. 11A), and a third display area (e.g., the third display area 1133 of FIG. 11A). The first display area may be disposed on the first housing. The second display area may be disposed on the second housing. The third display area may be disposed along the folding axis between the first display area and the second display area. The third display area may be configured to be deformed based on the second housing being rotated with respect to the first housing. According to an example embodiment, the exterior quality of an electronic device having a foldable structure may be improved by a low restoring force of a thermal interface material. For example, at least a portion of the flexible display may include a flexible area (e.g., a third display area) and thus may have a thin thickness. For flatness of the thin flexible display, the thermal interface material may have a low restoring force.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

While the disclosure has been illustrated and described with reference to various example embodiments, it will be understood that the various example embodiments are intended to be illustrative, not limiting. It will be further under understood by those skilled in the art that various changes in form and detail may be made without departing from the true spirit and full scope of the disclosure, including the appended claims and their equivalents. It will also be understood that any of the embodiment(s) described herein may be used in conjunction with any other embodiment(s) described herein.

## Claims

1. An electronic device comprising:
an electronic component disposed on a printed circuit board;
a shield can disposed on the printed circuit board at least partially surrounding the electronic component, wherein the shield can includes a first surface facing the electronic component, a second surface facing the first surface, and an opening passing through the first surface and the second surface, wherein the opening is aligned with the electronic component;
a shielding sheet disposed on the second surface of the shield can to cover the opening of the shield can; and
a thermal interface material, TIM, configured to transfer heat generated from the electronic component to the shielding sheet, and extending from a third surface of the electronic component facing the first surface, through at least a portion of the opening, to the shielding sheet, and
wherein the thermal interface material includes a phase change material, PCM, and is at least partially included in the shielding sheet.

2. The electronic device of claim 1,
wherein the thermal interface material at least partially penetrates into the shielding sheet.

3. The electronic device of claim 2,
wherein the thermal interface material at least partially penetrates into the shielding sheet, through a gap between the thermal interface material and the shielding sheet, based on being heat-compressed at a temperature higher than a glass transition temperature of the phase change material,

4. The electronic device of any one of claims 1 to 3,
wherein the thermal interface material contacts the third surface of the electronic component, and
wherein an area of the third surface in contact with the thermal interface material is greater than or equal to a specified ratio with respect to a total area of the third surface.

5. The electronic device of any one of claims 1 to 4, further comprising a housing including a supporting member comprising a support configured to support the printed circuit board and a plate disposed on the shielding sheet.

6. The electronic device of claim 5,
wherein the thermal interface material is configured to be compressed by a fastening force between the supporting member and the plate.

7. The electronic device of claim 6,
wherein the thermal interface material further comprises a matrix comprising rubber configured to provide a restoring force to expand toward the plate in a compressed state.

8. The electronic device of any one of claims 1 to 7,
wherein the thermal interface material is formed integrally with the shielding sheet.

9. The electronic device of any one of claims 1 to 8, further comprising:
a second electronic component spaced apart from the electronic component and at least partially surrounded by the shield can; and
a second thermal interface material configured to transfer heat generated from the second electronic component to the shield can, the second thermal interface material being distinct from the thermal interface material, and
wherein the second thermal interface material fills a space between the shield can and the second electronic component.

10. The electronic device of any one of claims 1 to 9,
wherein the shielding sheet is attached to the second surface through an adhesive member comprising an adhesive between the second surface and the shielding sheet.

11. The electronic device of any one of claims 1 to 10,
wherein the shielding sheet includes:
a first layer attached on the second surface through an adhesive member comprising an adhesive and comprising another thermal interface material distinct from the thermal interface material,
a second layer disposed on the first layer and configured to diffuse heat transferred from the first layer, and
a third layer disposed on the second layer and configured to radiate heat transferred from the second layer outside of the shielding sheet.

12. The electronic device of claim 11,
wherein the first layer and the second layer are configured to shield electromagnetic noise signals generated from the electronic component.

13. The electronic device of any one of claims 1 to 12,
wherein the electronic component includes at least one of a processor, a charging circuit, or a memory.

14. The electronic device of any one of claims 1 to 13, further comprising:
a first housing;
a second housing rotatably coupled to the first housing with respect to a folding axis; and
a flexible display including a folding area configured to be deformed based on the second housing being rotated with respect to the first housing.

15. The electronic device of any one of claims 1 to 14,
wherein the phase change material includes at least one of paraffin, salt hydrate, or polylactic acid, PLA, based composite.
